# FASCICULE DE BREVET EUROPEEN

(11) **EP 3 675 606 B1**
(45) Date de publication et mention de la délivrance du brevet: **29.01.2025**
(21) Numéro de dépôt: 19219734.1
(22) Date de dépôt: 26.12.2019
(51) Int. Cl.: H05K 1/11, H01R 12/72

(54) **CIRCUIT IMPRIME PERMETTANT D'AVOIR UN CONNECTEUR QSFP EN BELLY-TO-BELLY AVEC UN CONNECTEUR QSFP-DD ET SYSTEME ASSOCIE**
GEDRUCKTER SCHALTKREIS, DER EINEN QSFP-ANSCHLUSS »BELLY-TO-BELLY« MIT EINEM QSFP-DD-ANSCHLUSS ERMÖGLICHT, UND ENTSPRECHENDES SYSTEM
PRINTED CIRCUIT BOARD MAKING IT POSSIBLE TO HAVE A QSFP CONNECTOR IN BELLY-TO-BELLY WITH A QSFP-DD CONNECTOR AND ASSOCIATED SYSTEM

(30) Priorité: 27.12.2018 FR 1874225; 04.04.2019 FR 1903603
(43) Date de publication de la demande: 01.07.2020
(73) Titulaire: Bull SAS, 78340 Les Clayes-sous-Bois (FR); Commissariat à l'Energie Atomique et aux Energies Alternatives, 75015 Paris (FR)
(72) Inventeur: HASSOUNE, Ilham, 92160 Antony (FR); GUILBAULT, Pascal, 91370 Verrières-le-Buisson (FR); PIVETTE, Antoine, 78140 Vélizy (FR)
(74) Mandataire: Cabinet Camus Lebkiri

(56) Documents cités:
- CN-A- 108 156 748
- US-A1- 2008 112 674
- US-A1- 2018 034 211
- US-A1- 2019 208 633

## Description

### DOMAINE TECHNIQUE DE L'INVENTION

Le domaine technique de l'invention est celui des commutateurs d'interconnexion montables sur bâti, notamment les bâtis d'armoires informatique, permettant d'interconnecter les noeuds de calcul d'une armoire informatique.

La présente invention concerne un circuit imprimé permettant d'avoir un connecteur QSFP placé en belly-to-belly avec un connecteur QSFP-DD et un commutateur d'interconnexion 19 pouces 1U comprenant le circuit imprimé, montable sur un bâti d'armoire informatique et permettant d'avoir plus de 40 ports d'ASIC d'interconnexion.

### ARRIERE-PLAN TECHNOLOGIQUE DE L'INVENTION

Les armoires informatiques de l'état de la technique comprennent un bâti permettant d'accueillir des lames de calcul et des commutateurs d'interconnexion permettant d'interconnecter les noeuds de calcul compris dans les lames de calcul. L'interconnexion de noeuds de calcul permet de distribuer les calculs sur plusieurs noeuds.

La largeur totale du bac à cartes du bâti des armoires de calcul de l'état de la technique est de 482,6 mm, c'est-à-dire de 19 pouces, équerres de fixation comprises. Cette largeur est à l'origine du système de montage 19 pouces. Ainsi, la largeur des éléments accueillis par le bâti des armoires informatiques de l'état de la technique respecte ce standard de 19 pouces. Par la suite, lorsqu'on mentionnera un commutateur d'interconnexion « respectant le standard 19 pouces », on se référera à un commutateur d'interconnexion ayant une largeur de façade permettant d'être monté dans le bâti dans une armoire informatique de 19 pouces, c'est-à-dire par exemple dont la largeur de façade est de 19 pouces ou dont la largeur de façade est inférieure à 19 pouces.

Dans une armoire informatique de 19 pouces, l'espacement entre les éléments montables sur bâti, aussi dits « rackables », est habituellement un multiple d'une longueur nommée « unité de rack » (abréviation « U ») et qui mesure 1,75 pouces, soit 44,45 millimètres.

La hauteur d'une façade avant d'un équipement rackable n'est pas exactement un multiple entier de U car, pour permettre un montage facile d'équipements adjacents, un espace de 1/32 pouce, soit 0,031 pouce soit 0,79 mm, est laissé entre chaque façade. Ainsi, un élément ayant une façade de 1U aura une hauteur de 1,719 pouces, soit 43,66 millimètres. Par la suite, lorsqu'on mentionnera un commutateur d'interconnexion « 1U », on se référera à un commutateur d'interconnexion ayant une hauteur de façade permettant de respecter l'espacement d'une unité de rack (« 1U »), c'est-à-dire par exemple dont la hauteur de façade est de 1,719 pouces.

Au sein d'une armoire informatique, pour relier deux équipements, sont couramment utilisés des câbles optiques ou encore des câbles de cuivre. Pour les bus rapides, dont la vitesse est supérieure à 40 Gigabits par secondes, qui utilisent des liens à 10 Gigabits par secondes, à 25 Gigabits par secondes ou à 56 Gigabits par secondes modulés en PAM (selon la dénomination anglo-saxonne « Pulse Amplitude Modulation » pour « modulation de l'amplitude des impulsions »), le format très majoritairement utilisé est la format QSFP (selon la dénomination anglo-saxonne « Quad Small Form-Factor Pluggable »). Le QSFP est un émetteur-récepteur compact et connectable à chaud.

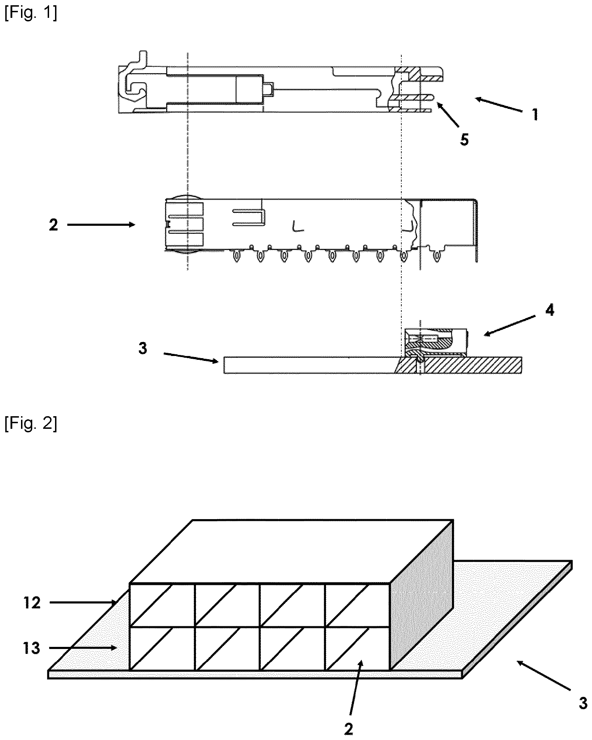

[Fig. 1] présente le format QSFP, et notamment un module émetteur-récepteur QSFP 1, une cage QSFP 2 permettant d'accueillir le module émetteur-récepteur 1, un circuit imprimé 3 sur lequel est montée la cage 2 et auquel est connecté le connecteur QSFP 4. Le module émetteur-récepteur 1 vient donc se connecter au connecteur 4 lors du branchement. Le module émetteur-récepteur 1 comprend une carte d'interface électronique 5 qui vient s'insérer dans le connecteur 4.

Les commutateurs d'interconnexion de l'état de l'art comprennent donc des connecteurs 4, des circuits imprimés 3 et des cages 2 permettant d'accueillir des émetteurs-récepteurs QSFP 1. Ces cages 2 font 21,33 millimètres de largeur. Ainsi, dans un commutateur d'interconnexion respectant le standard 19 pouces, il n'est possible de placer que maximum 20 cages 2 et donc 20 connecteurs 2 côte-à-côte.

Ces cages 2 ont une hauteur d'environ 12 millimètres. Ainsi, dans un commutateur d'interconnexion 1U, il est possible de mettre deux rangées de cages 2. Il n'est pas possible d'en avoir plus car le système de refroidissement des QSFP compris dans le commutateur d'interconnexion a aussi un encombrement non négligeable.

Pour avoir deux rangées de connecteurs 4 et de cages 2, deux dispositions sont utilisées dans l'état de la technique.

[Fig. 2] présente une première disposition de connecteurs 4 (non représentés), et donc de cages 2, disposés selon deux rangées. Une rangée 12 est empilée sur une rangée 13, dans une disposition dite « stacked » (selon la dénomination anglo-saxonne). La rangée 13 est en contact direct avec le circuit imprimé 3, et la rangée 12 est en contact direct avec la rangée 13. Les connecteurs 2 de chacune des deux rangées 12 et 13 sont connectés électriquement au circuit imprimé 3 grâce à une liaison électrique. Les connecteurs 4 de la rangée 13 peuvent par exemple être montés en surface du circuit imprimé 3 selon la technique de composants montés en surface (« CMS »).

Cette disposition empilée rend compliqué le refroidissement des émetteurs-récepteurs QSFP 1 lorsqu'ils sont branchés, en particulier les émetteurs-récepteurs 1 branchés dans les connecteurs 4 de la rangée 13. En effet, il est possible d'utiliser dissipateurs afin de faire passer ces dissipateurs au-dessus de la rangée 12, mais il n'est pas possible d'en faire de même pour la rangée 13. Cela convient cependant pour des émetteurs-récepteurs QSFP 1 qui peuvent consommer jusqu'à 3.5 Watts.

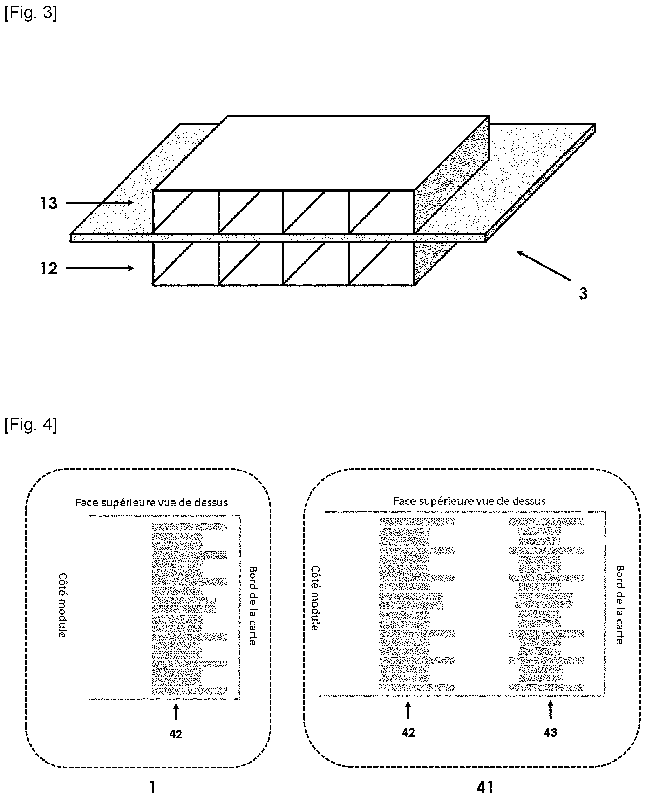

[Fig. 3] présente une seconde disposition de connecteurs 4 (non représentés), et donc de cages 2, disposés selon deux rangées. Une rangée 13 est en contact direct avec la face supérieure du circuit imprimé 3 et une rangée 12 est en contact direct avec la face inférieure du circuit imprimé 3, dans une disposition dite « belly-to-belly » (selon la dénomination anglo-saxonne, qui se traduit littéralement en « ventre-à-ventre » en français). Les connecteurs 2 de chacune des deux rangées 12 et 13 sont connectés électriquement au circuit imprimé 3 grâce à une liaison électrique. Les connecteurs 4 de la rangée 12 peuvent par exemple être montés sur la face supérieure du circuit imprimé 3 selon la technique de composants montés en surface (« CMS »). Les connecteurs 4 de la rangée 13 peuvent par exemple être montés sur la face inférieure du circuit imprimé 3 selon la technique de composants montés en surface (« CMS »).

Cette disposition en belly-to-belly a pour avantage de faciliter le refroidissement de émetteurs-récepteurs QSFP 1 lorsqu'ils sont branchés en ayant la possibilité d'utiliser des TIM afin de faire passer ces TIM au-dessus de la rangée 13 et en-dessous de la rangée 12.

Avec deux rangées de connecteurs QSFP 4, on trouve donc dans l'état de l'art des commutateurs d'interconnexion 19 pouces 1U ayant 36 à 40 ports.

Les ASIC (selon la dénomination anglo-saxonne « Application-Specific Integrated Circuit » pour « Circuit Intégré Propre à une Application ») d'interconnexion de l'état de la technique comprenaient jusqu'alors 36 à 40 ports. Les commutateurs d'interconnexion comprenant 36 à 40 ports suffisaient donc pour les ASICs d'interconnexion utilisés.

Cependant, avec les avancées dans le domaine micro-électronique, des ASICs comprenant plus de 40 ports, par exemple comprenant 48 voire 64 ports, commencent à voir le jour. Le facteur limitant devient donc le nombre de connecteurs 4 que l'on peut mettre en face avant d'un commutateur d'interconnexion 19 pouces 1U.

Une possibilité pourrait être d'augmenter la largeur des commutateurs d'interconnexion mais ceux-ci ne respecteraient alors plus le standard 19 pouces. De plus, une augmentation de la largeur entraînerait une augmentation de la longueur des pistes du circuit imprimé 3 connectées aux connecteurs 4, et donc des pertes de signal plus importantes.

La solution choisie dans l'état de la technique est donc de réduire l'encombrement des connecteurs 4. Cependant, le format QSFP est largement adopté pour les applications de données performantes et sensibles aux coûts et les différents acteurs de ce marché ne souhaitent pas changer pour d'autre format plus dense comme le micro-QSFP. C'est pourquoi un nouveau format est développé, appelé QSFP-DD pour « Quad Small Form-Factor Pluggable Double-Density ». Un connecteur QSFP-DD a le même encombrement en face avant qu'un connecteur 4 QSFP, mais il permet de doubler le nombre de liens par rapport à un connecteur 4 QSFP. Pour cela une deuxième ligne de contacts a été ajouté à l'interface électrique, comme illustré Figure 4.

[Fig. 4] présente la face supérieure de la carte d'interface électrique 5 d'un module émetteur-récepteur 1 QSFP et la face supérieure de la carte d'interface électrique 5 vue de dessus d'un module émetteur-récepteur 41 QSFP-DD.

La face supérieure de la carte d'interface électrique 5 du module émetteur-récepteur QSFP 1 comprend 19 contacts 42. Dans le nouveau format, la face supérieure de la carte d'interface électrique 5 du module émetteur-récepteur QSFP-DD 41 comprend une seconde ligne de 19 contacts 43 en plus des 19 contacts 42 du format QSFP. Grâce à cela, le QSFP-DD est rétro-compatible avec le QSFP, un module émetteur-récepteur QSFP 1 pouvant être branché à un connecteur QSFP-DD via la ligne de contacts la plus proche de l'entrée du connecteur.

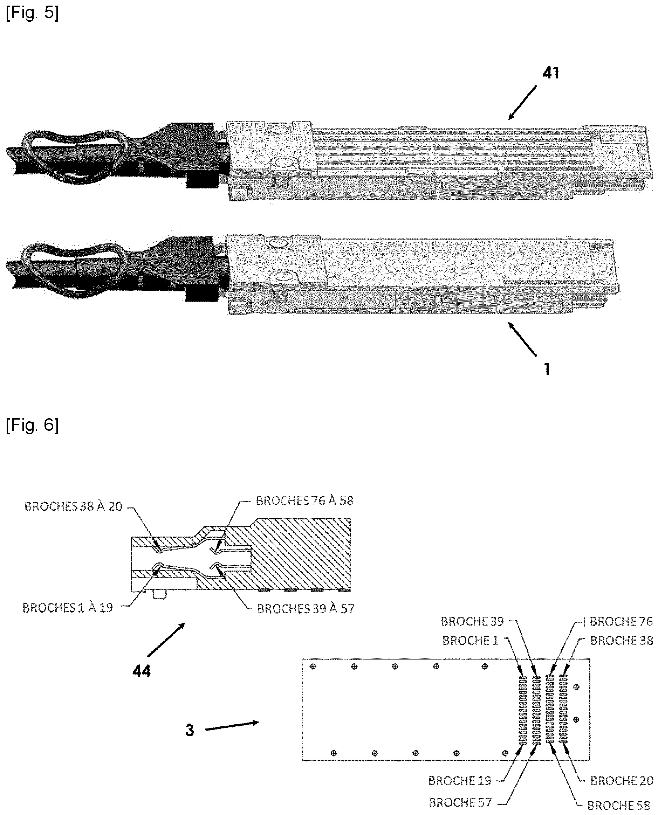

[Fig. 5] représente les deux modules émetteurs-récepteurs 1 et 41 respectivement QSFP et QSFP-DD. La Figure 5 illustre la différence de dimensions entre les deux modules émetteurs-récepteurs, rendant possible la rétrocompatibilité des connecteurs QSFP-DD avec des modules émetteurs-récepteurs 1 QSFP.

Avec le format QSFP « Double-Densité », on peut donc avoir deux ports d'un ASIC d'interconnexion routés à un connecteur pour un encombrement d'un seul connecteur en face avant. Le module émetteur-récepteur QSFP-DD 41 doit alors contenir deux fois plus d'émetteurs-récepteurs et devient donc plus long et peut consommer jusqu'à 15 Watts.

Avec une telle consommation, il devient beaucoup plus complexe de refroidir ces modules, notamment lorsqu'ils sont en disposition de rangées empilées. Concernant cette disposition en particulier, elle n'est pas au point, surtout pour les liens rapides 400Gigabits par secondes (8 liens à 50Gigabits par secondes modulés en PAM4) car il est très difficile de refroidir deux modules émetteurs-récepteurs QSFP-DD 41 de 15 Watts l'un au-dessus de l'autre, surtout pour le module du dessous, car il est proche du circuit imprimé 3. En effet, il n'est pas en contact avec le haut de la cage ou l'on peut placer un radiateur, un dissipateur, ou tout autre moyen de refroidissement.

Il serait possible de refroidir le module 41 du dessous si le module émetteur-récepteur 41 de la rangée 13 du bas est uniquement un module cuivre qui ne chauffe pas ou peu ce qui n'est pas le cas pour les modules émetteurs-récepteurs QSFP-DD rapides.

De plus, dans une disposition à rangées empilées, des problèmes d'intégrité du signal interviennent. Des pertes et de la diaphonie importantes au niveau du connecteur surtout concernant le lien qui va du circuit imprimé 3 vers un connecteur situé dans la rangée 12 supérieure. Cela pose un problème pour les liens rapides dont la vitesse de transmission est supérieure à 2 * 100 Gigabits par secondes comme par exemple 400 Gigabits par secondes (8 liens à 50Gigabits par secondes modulés en PAM4). Ces pertes dans le connecteur ne permettent pas d'avoir un bon canal en termes d'intégrité du signal à moins d'essayer de compenser au niveau du circuit imprimé 3 par des matériaux et technologies PCB (selon la dénomination anglo-saxonne « Printed Circuit Board» pour « circuit imprimé ») complexes.

Au niveau du circuit imprimé 3, l'empreinte du connecteur change pour ajouter les broches correspondant à la seconde rangée 43 et on obtient un circuit imprimé 3 avec 4 séries de broches comme représenté Figure 6.

[Fig. 6] représente un connecteur QSFP-DD 44 comprenant deux mâchoires comprenant chacune 19 broches en haut et 19 broches en bas, soit 76 broches en tout, et le circuit imprimé 3 comprenant 4 rangées de 19 pastilles destinées à être en liaison électrique avec le connecteur 44 QSFP-DD. La correspondance des pastilles avec les broches du connecteur QSFP-DD 4 est illustrée au niveau du circuit imprimé 3. Le connecteur 44 est vu en coupe de côté, et le circuit imprimé 3 est vu de dessus.

Lorsque le module émetteur-récepteur QSFP-DD 41 est branché au connecteur 44, chacune des 76 broches du connecteur QSFP-DD 44 est connectée à une broche du module émetteur-récepteur QSFP-DD 41. Le connecteur 44 QSFP-DD est connecté au circuit imprimé selon la technique CMS, et chaque pastille des 4 rangées de pastilles du circuit imprimé 3 récupère les données provenant de la broche correspondante du connecteur QSFP-DD 44.

Avec ces 4 rangées de pastilles sur le circuit imprimé 3, il est nécessaire de réaliser des vias à proximité des 2 rangées de pastilles du milieu, c'est-à-dire la rangée recevant les données des broches 39 à 57 et la rangée recevant les données des broches 58 à 76.

En utilisant des via traversants pour cela, il n'est plus possible de décaler suffisamment les vias pour mettre les rangées de connecteurs QSFP-DD en disposition Belly-to-Belly. En effet, en disposition Belly-to-Belly, il ne faut pas avoir de broche d'un connecteur 44 QSFP-DD se situant sous un via connecté aux broches d'un autre connecteur 44 placé sur l'autre face du circuit imprimé 3. La seule solution est d'utiliser des micro-vias et d'ajouter des couches de circuit imprimé ce qui rend le circuit imprimé 3 complexe et coûteux à fabriquer.

Toutes ces contraintes font qu'il est compliqué de concevoir des systèmes avec 2 rangées de connecteurs 44 QSFP-DD qui puissent être correctement refroidis et qui ne nécessitent pas de technologies PCB complexes et coûteuses.

Le document CN 108156748 A (US 2019/208633 A1) décrit un circuit imprimé permettant d'avoir deux connecteurs QSFP-DD en Belly-To-Belly sur quatre couches de PCB en utilisant des vias borgnes et des vias traversants.

Le document US 2008/112674 A1 décrit des connecteurs QSFP-DD.

### RESUME DE L'INVENTION

L'invention offre une solution aux problèmes évoqués précédemment, en permettant dans un commutateur 19 pouces de 1U montable sur bâti d'avoir plus de 40 ports, compatible avec un refroidissement liquide, et permettant de ne pas utiliser des technologie PCB complexes et coûteuses telles que les microvias ou les PCB multi pressés.

Un aspect de l'invention concerne un circuit imprimé selon la revendication 1.

Grâce à l'invention, il est possible d'avoir plus de 40 ports dans un commutateur d'interconnexion 19 pouces de 1U montable sur bâti.

Avantageusement, l'invention permet, en ayant une disposition d'au moins un connecteur QSFP en Belly-to-Belly avec un connecteur QSFP-DD, d'utiliser un refroidissement liquide efficace en utilisant un système de refroidissement passant au-dessus de la rangée de connecteurs supérieurs et en passant en-dessous de la rangée de connecteurs inférieurs. En effet, avec des connecteurs de chaque côté du PCB, il est possible de choisir des cages QSFP et QSFP-DD ayant une surface plane afin d'y coller des matériaux d'interface thermique (TIM) venant en contact avec le dissipateur et permettent un bon refroidissement des QSFP et QSFP-DD.

De plus, cette disposition permet avantageusement, grâce à la différence de dimensions des connecteurs QSFP et des connecteurs QSFP-DD, d'avoir un agencement des broches des connecteurs de sorte que l'on puisse utiliser des vias traversants sans avoir de broche d'un connecteur se situant sous un via connecté aux broches d'un autre connecteur placé sur l'autre face du circuit imprimé. Cela permet avantageusement de ne pas avoir à utiliser de microvias.

L'invention permet avantageusement d'avoir trois ports dans une disposition où un connecteur QSFP est en Belly-to-Belly avec un connecteur QSFP-DD, tout en routant les liens rapides des trois ports sur seulement quatre couches de circuit imprimé au lieu de six en temps normal.

L'invention permet d'éviter des technologie PCB compliquées et coûteuses telles que l'utilisation de microvias ou encore les PCB multi-pressés tout en garantissant une bonne qualité d'intégrité du signal, nécessaire pour les liens hautes vitesse allant jusqu'à 56Gigabits par secondes modulés en PAM4. L'intégrité du signal est conservée en routant avantageusement les signaux d'émission et de réception sur des couches de circuit imprimé différentes, permettant d'éviter la diaphonie entre les signaux.

Un autre aspect de l'invention concerne un système d'interconnexion selon la revendication 8 comprenant le circuit imprimé selon la revendication 1.

L'invention est définie par les revendications annexées, et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La Figure 1 montre une représentation schématique d'un module émetteur-récepteur QSFP, d'une cage QSFP, d'un circuit imprimé sur lequel la cage est montée et auquel est connecté un connecteur QSFP.
- La Figure 2 montre une représentation schématique d'une première disposition de rangées de cages QSFP empilées vue de face.
- La Figure 3 montre une représentation schématique d'une seconde disposition de rangées de cages QSFP en « belly-to-belly » vue de face.
- La Figure 4 montre une représentation schématique de la face supérieure d'une carte d'interface électrique d'un module émetteur-récepteur QSFP et la face supérieure d'une carte d'interface électrique d'un module émetteur-récepteur QSFP-DD.
- La Figure 5 montre une représentation de deux modules émetteurs-récepteurs QSFP et QSFP-DD.
- La Figure 6 montre une représentation schématique d'un connecteur QSFP-DD vu en coupe de côté et de la face supérieure d'un circuit imprimé vu de dessus permettant de connecter le connecteur QSFP-DD.
- La Figure 7 montre une représentation schématique d'un système comprenant un connecteur QSFP-DD, un connecteur QSFP et un circuit imprimé selon un premier mode de réalisation de l'invention.
- La Figure 8 montre une représentation schématique de la face inférieure du circuit imprimé selon l'invention dans un premier mode de réalisation.
- La Figure 9 montre une représentation schématique de la face supérieure du circuit imprimé selon l'invention dans un premier mode de réalisation.
- La Figure 10 montre une représentation schématique du circuit imprimé selon l'invention vu en coupe selon un plan perpendiculaire au plan du circuit imprimé.
- La Figure 11 montre une représentation schématique des couches de réception du circuit imprimé selon l'invention.
- La Figure 12 montre une représentation schématique des couches d'émission du circuit imprimé selon l'invention.
- La Figure 13 montre une représentation schématique d'un système comprenant un connecteur QSFP-DD, un connecteur QSFP et un circuit imprimé selon une variante du premier mode de réalisation de l'invention.
- La Figure 14 montre une représentation schématique d'un système comprenant plusieurs connecteur QSFP-DD, plusieurs connecteur QSFP et un circuit imprimé selon un troisième mode de réalisation de l'invention.
- La Figure 15 montre une représentation schématique de la face inférieure du circuit imprimé selon l'invention selon une variante du premier mode de réalisation.
- La Figure 16 montre une représentation schématique d'un commutateur d'interconnexion selon l'invention.

### DESCRIPTION DETAILLEE D'AU MOINS UN MODE DE REALISATION DE L'INVENTION

Les figures sont présentées à titre indicatif et nullement limitatif de l'invention.

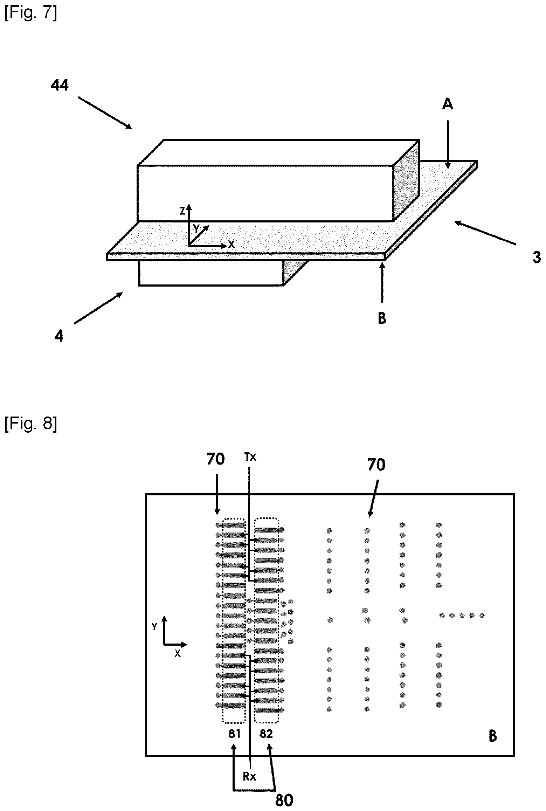

[Fig. 7] montre une représentation schématique d'un système comprenant un connecteur QSFP-DD 44, un connecteur QSFP 4 et un circuit imprimé 3 selon l'invention.

Selon un premier mode de réalisation, un connecteur QSFP-DD 44 est disposé en Belly-To-Belly avec un connecteur QSFP 4, le connecteur QSFP-DD 44 étant séparé du connecteur QSFP 4 par un circuit imprimé 3. Le circuit imprimé 3 comprend deux faces A et B, une pluralité de pastilles (non représentée) et une pluralité de vias traversants (non représentés). Le connecteur QSFP-DD 44 peut être placé sur la rangée du haut et être connecté à une première face, par exemple la face supérieure A du circuit imprimé comme représenté à la Figure 6 de manière non limitative. Dans ce cas, le connecteur QSFP 4 sera placé sur la rangée du bas et sera connecté à une seconde face, opposée à la première face, c'est-à-dire que le connecteur QSFP 4 sera connecté à la face inférieure B du circuit imprimé 3.

Dans une variante au premier mode de réalisation, la première face peut aussi être la face inférieure B, le connecteur QSFP-DD 44 étant alors placé sur la rangée du bas et connecté à la face inférieure B du circuit imprimé 3. Dans ce cas, le connecteur QSFP 4 sera placé sur la rangée du haut et sera connecté à la seconde face, opposée à la première face, c'est-à-dire que le connecteur QSFP 4 sera connecté à la face supérieure A du circuit imprimé 3.

[Fig. 8] représente la face inférieure B du circuit imprimé 3 dans le premier mode de réalisation, c'est-à-dire dans le mode de réalisation où le connecteur QSFP-DD 44 est connecté à la face supérieure A du circuit imprimé 3 et où le connecteur QSFP 4 est connecté à la face inférieure B du circuit imprimé 3.

Dans ce premier mode de réalisation, la face inférieure B du circuit imprimé 3 comprend un premier sous-ensemble de pastilles 80 et une pluralité de vias traversants 70.

On entend par « pastille » une zone conductrice du circuit imprimé 3 réalisée en métal. Cette zone permet par exemple de fixer un composant tel qu'un connecteur QSFP 4 ou QSFP-DD 44 selon la technique des « composants montés en surface ».

On entend par « via » un trou métallisé permettant d'établir une liaison électrique entre deux couches. On entend par « via traversant » un trou métallisé traversant l'ensemble des couches constitutives d'un circuit imprimé 3.

Le premier sous-ensemble de pastilles 80 est compris dans la pluralité de pastilles du circuit imprimé 3. Ce premier sous-ensemble de pastilles 80 permet la connexion d'un connecteur QSFP 4 à la face inférieure B du circuit imprimé 3, comme représenté Figure 7.

Ce premier sous-ensemble de pastilles 80 comprend deux rangées de pastilles 81 et 82. La rangée 81 comprend des pastilles permettant par exemple la connexion avec les broches 1 à 19 d'un connecteur QSFP 4 et la rangée 82 comprend des pastilles permettant par exemple la connexion avec les broches 20 à 38 d'un connecteur QSFP 4. A chaque pastille des rangées de pastilles 81 et 82 est connecté un via traversant. Une pluralité de vias traversants 70 est représentée Figure 8. Certains vias ne sont pas connectés à une pastille comprise dans les rangées 81 et 82. Dans le premier mode de réalisation, ces vias traversants sont connectés à des pastilles de la face supérieure A permettant la connexion avec les broches d'un connecteur QSFP-DD 44. Un avantage de la présente invention est ainsi de pouvoir utiliser des vias traversants et de ne pas avoir à utiliser des microvias ou des PCB multipressés. En effet, l'invention utilise avantageusement la différence de dimensions d'un connecteur QSFP-DD 44 par rapport à un connecteur QSFP 4, permettant ainsi d'utiliser des vias traversants sans avoir de broche d'un connecteur QSFP 4 sur la face inférieure B étant sous un via connecté à une pastille du connecteur QSFP-DD 44 sur la face supérieure A.

De façon connue de l'homme du métier, le premier sous-ensemble de pastilles 80 comprend des pastilles de réception Rx et des pastilles d'émission Tx. On entend par « pastille de réception » une pastille pour la connexion avec une broche de réception d'un connecteur QSFP 4 ou QSFP-DD 44. Dans le premier sous-ensemble de pastilles 80, les pastilles de réception permettent la connexion à une broche de réception d'un connecteur QSFP 4. On entend par « pastille d'émission » une pastille pour la connexion avec une broche d'émission d'un connecteur QSFP 4 ou QSFP-DD 44. Dans le premier sous-ensemble de pastilles 80, les pastilles d'émission permettent la connexion à une broche de réception d'un connecteur QSFP 4.

Chaque pastille de réception Rx et chaque pastille d'émission Tx du premier sous-ensemble de pastilles 80 est connectée à un via traversant de la pluralité de vias traversants 70, comme représenté à la Figure 8. Un via traversant de la pluralité de vias traversants 70 connecté à une pastille de réception Rx est appelé un « via traversant dédié à la réception », et ce indépendamment de la face supérieure A ou inférieure B sur laquelle il est connecté à une pastille de réception Rx. De la même manière, un via traversant de la pluralité de vias traversants 70 connecté à une pastille d'émission Tx est appelé un « via traversant dédié à l'émission », et ce indépendamment de la face supérieure A ou inférieure B sur laquelle il est connecté à une pastille d'émission Tx. Chaque via dédié à la réception et chaque via dédié à l'émission est aligné avec la pastille de réception ou d'émission auquel il est connecté selon l'axe longitudinal X. Cela permet d'avoir un espacement entre les vias de 0.8millimètres. Le diamètre du via doit être optimisé en fonction de l'épaisseur du PCB, du pitch du connecteur et les possibilités du routage des signaux dans la région du connecteur, de façon à approcher le plus possible l'impédance nominale du canal qui est 100Ohms. Dans le cas présent, un diamètre de trou du via par exemple de 0.275mm permet d'obtenir un canal avec des performances intégrité de signal optimales.

Un via traversant de la pluralité de vias traversant 70 connecté à une pastille de réception Rx du premier sous-ensemble de pastilles 80 sur la face inférieure B n'est connecté à aucune autre pastille d'émission Tx ou de réception Rx de la face inférieure B ni à aucune autre pastille d'émission Tx ou de réception Rx sur la face supérieure A.

La pluralité de vias traversants 70 est accessible à partir de n'importe laquelle des deux faces supérieure A ou inférieure B, car un via traversant de la pluralité de vias traversants 70 traverse l'ensemble des couches comprises dans le circuit imprimé 3.

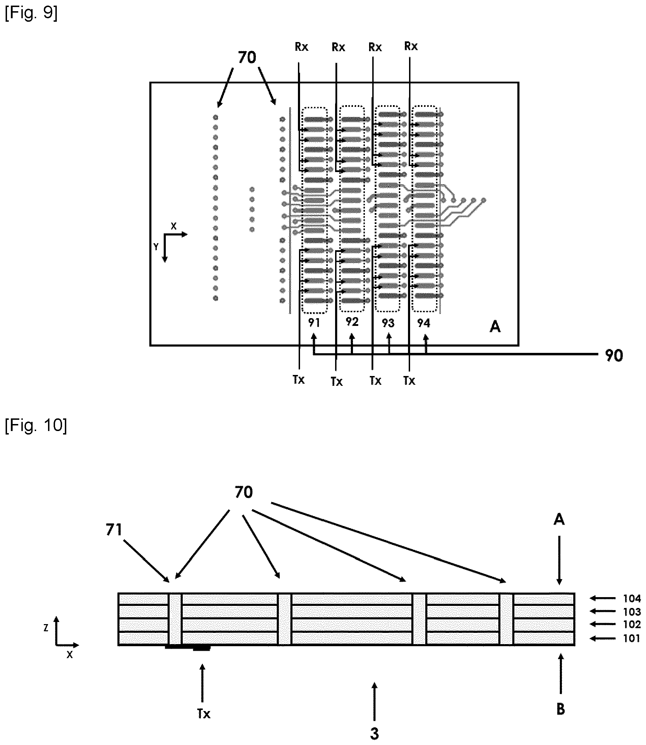

[Fig. 9] représente la face supérieure A du circuit imprimé 3 dans le premier mode de réalisation, c'est-à-dire dans le mode de réalisation où le connecteur QSFP-DD 44 est connecté à la face supérieure A du circuit imprimé 3 et où le connecteur QSFP 4 est connecté à la face inférieure B du circuit imprimé 3.

Dans ce premier mode de réalisation, la face supérieure A du circuit imprimé 3 comprend un second sous-ensemble de pastilles 90 et une pluralité de vias traversants 70.

Le second sous-ensemble de pastilles 90 est compris dans la pluralité de pastilles du circuit imprimé 3. Ce second sous-ensemble de pastilles 90 permet la connexion d'un connecteur QSFP-DD 44 à la face supérieure A du circuit imprimé 3, comme représenté Figure 7.

Comme représenté à la Figure 9, ce second sous-ensemble de pastilles 90 est décalé par rapport au premier sous-ensemble de pastilles 80 selon l'axe longitudinal X.

On entend par « axe longitudinal X » un axe dont l'origine est un bord du circuit imprimé 3 et allant vers l'intérieur du circuit imprimé 3.

Par exemple, et dans un mode de réalisation préférentiel représenté Figure 9, l'axe longitudinal X part du bord du circuit imprimé 3 où se branchent les modules émetteurs-récepteurs QSFP 1 et QSFP-DD 41 dans les connecteurs QSFP 4 et QSFP-DD 44 et suit l'axe longitudinal des connecteurs QSFP 4 et QSFP-DD 44 comme représenté à la Figure 7.

Le second sous-ensemble de pastilles 90 comprend quatre rangées de pastilles 91 à 94. La rangée 91 comprend des pastilles permettant par exemple la connexion avec les broches 1 à 19 d'un connecteur QSFP-DD 44, la rangée 92 comprend des pastilles permettant par exemple la connexion avec les broches 39 à 57 d'un connecteur QSFP-DD 44, la rangée 93 comprend des pastilles permettant par exemple la connexion avec les broches 76 à 58 d'un connecteur QSFP-DD 44 et la rangée 94 comprend des pastilles permettant par exemple la connexion avec les broches 20 à 38 d'un connecteur QSFP-DD 44. A chaque pastille des rangées de pastilles 91 à 94 est connecté un via traversant. La pluralité de vias traversants 70 est représentée Figure 9. Certains vias traversants ne sont pas connectés à une pastille comprise dans les rangées 91 à 94. Ces vias traversants non connectés à une pastilles sur la face supérieure A sont par exemple connectés à une pastille du premier sous-ensemble de pastilles 80 de la face inférieure B.

Des vias traversants de la pluralité de vias traversants 70 sont connectés à des pastilles de la face supérieure A permettant la connexion avec les broches d'un connecteur QSFP-DD 44. L'invention utilise avantageusement la différence de dimensions d'un connecteur QSFP-DD 44 par rapport à un connecteur QSFP 4, permettant ainsi d'utiliser des vias traversants sans avoir de broche d'un connecteur QSFP-DD 44 sur la face supérieure A étant sur un via connecté à une pastille du connecteur QSFP 4 sur la face inférieure B.

De façon connue de l'homme du métier, le second sous-ensemble de pastilles 90 comprend des pastilles de réception Rx et des pastilles d'émission Tx. On entend par « pastille de réception » une pastille pour la connexion avec une broche de réception d'un connecteur QSFP 4 ou QSFP-DD 44. Dans le second sous-ensemble de pastilles 90, les pastilles de réception permettent la connexion à une broche de réception d'un connecteur QSFP-DD 44. On entend par « pastille d'émission » une pastille pour la connexion avec une broche d'émission d'un connecteur QSFP 4 ou QSFP-DD 44. Dans le second sous-ensemble de pastilles 90, les pastilles d'émission permettent la connexion à une broche de réception d'un connecteur QSFP-DD 44.

Chaque pastille de réception Rx et chaque pastille d'émission Tx du second sous-ensemble de pastilles 90 est connectée à un via traversant de la pluralité de vias traversants 70, comme représenté à la Figure 9. Un via traversant de la pluralité de vias traversants 70 connecté à une pastille de réception Rx est appelé un « via traversant dédié à la réception », et ce indépendamment de la face supérieure A ou inférieure B sur laquelle il est connecté à une pastille de réception Rx. De la même manière, un via traversant de la pluralité de vias traversants 70 connecté à une pastille d'émission Tx est appelé un « via traversant dédié à l'émission », et ce indépendamment de la face supérieure A ou inférieure B sur laquelle il est connecté à une pastille d'émission Tx. Chaque via dédié à la réception et chaque via dédié à l'émission est aligné avec la pastille de réception ou d'émission auquel il est connecté selon l'axe longitudinal X. Cela permet d'avoir un espacement entre les vias de 0.8 millimètres. Le diamètre du via doit être optimisé en fonction de l'épaisseur du PCB, de façon à approcher le plus possible l'impédance nominale du canal qui est 100 Ohms. Dans le cas présent, un diamètre de trou du via par exemple de 0.275mm permet d'obtenir un canal avec des performances intégrité de signal optimales

Un via traversant de la pluralité de vias traversant 70 connecté à une pastille de réception Rx du second sous-ensemble de pastilles 90 sur la face supérieure A n'est connecté à aucune autre pastille d'émission Tx ou de réception Rx de la face supérieure A ni à aucune autre pastille d'émission Tx ou de réception Rx sur la face inférieure B.

Comme indiqué précédemment, la pluralité de vias traversants 70 est accessible à partir de n'importe laquelle des deux faces supérieure A ou infréieure B, car un via traversant de la pluralité de vias traversants 70 traverse l'ensemble des couches comprises dans le circuit imprimé 3.

[Fig. 10] représente schématiquement le circuit imprimé 3 vu en coupe selon un plan perpendiculaire au plan du circuit imprimé 3, c'est-à-dire selon un plan suivant les axes X et Z, comme représentés aux Figures 7 et 10.

Le circuit imprimé 3 comprend quatre couche 101 à 104 et une pluralité de vias traversants 70. Un avantage d'utiliser des vias traversants est de n'avoir que quatre couches de circuit imprimé 3 au lieu de six couches normalement. En effet, en utilisant des microvias avec des sous-ensembles de pastilles 80 et 90 étant en regard l'un de l'autre, le premier sous-ensemble de pastilles 80 correspondant à la connexion avec un connecteur QSFP 4, aurait nécessité deux couches : une couche pour router les signaux de réception (Rx) et une couche pour router les signaux d'émission (Tx), car le connecteur QSFP 4 ne permet de router qu'un port provenant du ASIC d'interconnexion. Le second sous-ensemble de pastilles 90 correspondant à la connexion avec un connecteur QSFP-DD 44 aurait nécessité quatre couches : deux couches pour router les signaux de réception (Rx) correspondant à chacun des deux ports du ASIC d'interconnexion et deux couches pour router les signaux d'émission (Tx) correspondant à chacun des deux ports du ASIC d'interconnexion. En utilisant des vias traversants il est donc possible de n'avoir que 4 couches pour router les signaux de 3 ports du ASIC d'interconnexion vers les deux connecteurs 4 QSFP et 44 QSFP-DD. Cette utilisation de vias traversants est rendue possible grâce au fait que les deux sous-ensembles de pastilles 80 et 90 sont décalés l'un de l'autre selon l'axe longitudinal X du circuit imprimé 3 de façon à ce qu'aucune pastille d'un sous-ensemble ne soit en regard d'aucune pastille d'un autre sous-ensemble.

Parmi ces quatre couches du circuit imprimé 3, deux couches sont des couches de réception, c'est-à-dire comprenant une pluralité de pistes de réception, et deux couches sont des couches d'émission, c'est-à-dire comprenant une pluralité de pistes d'émission. Cette séparation des couches en couches d'émission et couches de réception permet de respecter les règles de routage des signaux entre les connecteurs QSFP et QSFP-DD et les ports du ASIC d'interconnexion et ainsi d'éviter la diaphonie entre les signaux. Par exemple, dans le premier mode de réalisation, les couches 101 et 102 peuvent être des couches de réception et les couches 103 et 104 peuvent être des couches d'émission. Dans une variante, les couches 101 et 103 peuvent être des couches de réception et les couches 102 et 104 peuvent être des couches d'émission. D'autres variantes peuvent être mises en oeuvre dans lesquelles d'autres combinaisons peuvent être utilisées.

Un via traversant 71 de la pluralité de vias traversants 70 est par exemple Figure 10 un via traversant dédié à l'émission. En effet, le via traversant 71 est connecté à une pastille d'émission Tx qui est une pastille du premier sous-ensemble de pastilles 80 sur la face inférieure B dans le premier mode de réalisation. Ce via traversant 71 permet d'établir une liaison électrique entre les différentes couches 101 à 104 et avec la pastille d'émission Tx. Ainsi, il est possible de récupérer le signal d'émission de la broche d'émission du connecteur QSFP 4 de la face inférieure B du premier mode de réalisation connectée à la pastille d'émission Tx, en reliant une piste d'émission d'une des couches 101 à 104 au via traversant 71.

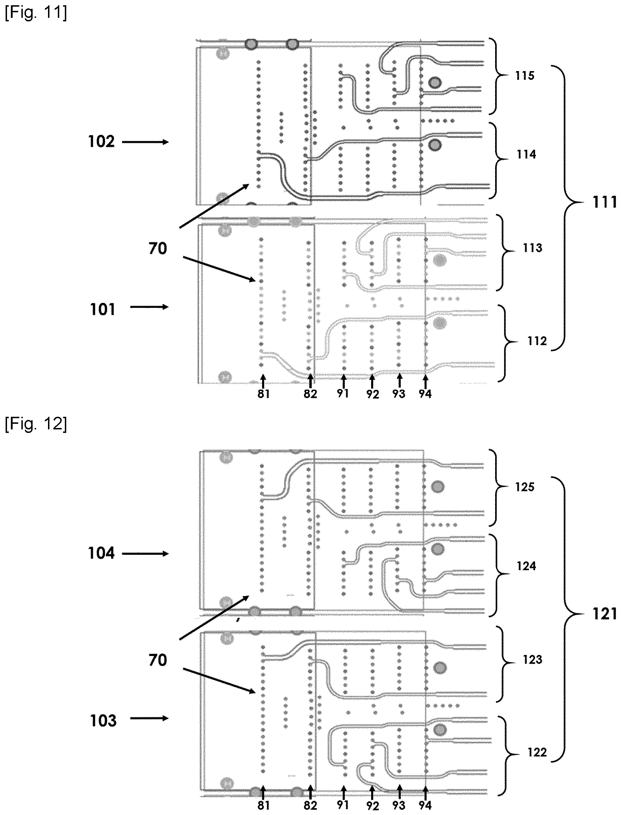

[Fig. 11] représente schématiquement les couches 101 et 102 de réception du circuit imprimé 3. Ces couches 101 et 102 comprennent une pluralité de pistes de réception 111. Chaque piste de réception de la pluralité de pistes de réception 111 permet de récupérer un signal de réception et est reliée à un via dédié à la réception auquel aucune autre piste de réception de la pluralité de pistes de réception 111 n'est connectée. Un signal de réception provenant d'un module émetteur-récepteur QSFP 1 ou QSFP-DD 41 est transmis à un connecteur QSFP 4 ou QSFP-DD 44 puis est récupéré au niveau d'une pastille de réception d'un sous-ensemble de pastilles 80 ou 90 à laquelle est connectée une broche de réception du connecteur QSFP 4 ou QSFP-DD 44. Ce signal circule ensuite au niveau d'un via traversant dédié à la réception connecté à la pastille de réception. Ce via traversant dédié à la réception permet ainsi d'établir un contact électrique dans les couches 101 à 104 à la pastille de réception et donc de récupérer le signal de réception. Le signal de réception est récupéré dans une des couches de réception 101 ou 102 par un piste de réception reliée au via traversant dédié à la réception. Ce signal est ensuite acheminé au port du ASIC d'interconnexion correspondant par la piste de réception.

On entend par « piste de réception » une zone métallisée permettant d'établir un contact entre un via traversant dédié à la réception de la pluralité de vias traversants 70 et un port du ASIC d'interconnexion.

Un connecteur QSFP comprend 8 broches de réception, le premier sous-ensemble de pastilles 80 comprend donc 8 pastilles de réception Rx pour la connexion avec ces 8 broches de réception. Les 8 vias dédiés à la réception connectés à ces 8 pastilles de réception Rx permettent donc de récupérer le signal de réception dans les couches 101 et 102. Chaque couche de réception 101 et 102 comprend donc chacune un premier sous-ensemble de pistes de réception dédiée à récupérer le signal de réception provenant d'un connecteur QSFP 4 respectivement 112 et 114.

Un couple de pistes de réception comprend deux pistes de réception : une première piste de réception reliée à un premier via dédié à la réception et une seconde piste de réception reliée à un second via traversant dédié à la réception, voisin du premier via traversant dédié à la réception.

On entend par « voisin du premier via dédié à la réception » un second via dédié à la réception situé directement à côté du premier via dédié à la réception, c'est-à-dire qu'aucun autre via dédié à la réception ne sépare le premier et le second vias dédiés à la réception. Un via dédié à la réception sépare un premier et un second vias dédiés à la réception s'il est situé sur un axe passant par le centre du premier via dédié à la réception et du second via dédié à la réception. Ainsi, pour obtenir le second via dédié à la réception voisin d'un premier via dédié à la réception, on cherche le via dédié à la réception dont la distance centre-à-centre avec le premier via dédié à la réception est la plus faible parmi la pluralité de vias dédiés à la réception.

Pour former les couples de pistes de réception compris dans les premiers sous-ensembles de pistes de réception 112 et 114, on cherchera donc des couples de vias dédiés à la réception voisins. Dans le premier mode de réalisation, un exemple de couples de vias dédiés à la réception et donc de couples de pistes de réception compris dans les premiers sous-ensembles 112 et 114 sont représentés à la Figure 11.

Le premier sous-ensemble 112 comprend donc par exemple deux couples de pistes de réception. Un premier couple de pistes de réception comprend deux pistes de réception, chacune reliée à un via traversant dédié à la réception de la rangée 81. Un second couple de pistes de réception comprend deux pistes de réception, chacune reliée à un via traversant dédié à la réception de la rangée 82. Les signaux de réception de quatre pastilles de réception sont ainsi récupérés par le premier sous-ensemble de pistes de réception 112.

Le premier sous-ensemble 114 comprend par exemple deux autres couples de pistes de réception. Un premier couple de pistes de réception comprend deux pistes de réception, chacune reliée à un via traversant dédié à la réception de la rangée 81, différents des deux vias dédiés à la réception déjà reliés au premier couple de pistes de réception du premier sous-ensemble 112. Un second couple de pistes de réception comprend deux pistes de réception, chacune reliée à un via traversant dédié à la réception de la rangée 82, différents des deux vias dédiés à la réception déjà reliés au premier couple de pistes de réception du premier sous-ensemble 112. Les signaux de réception de quatre autres pastilles de réception sont ainsi récupérés par le premier sous-ensemble de pistes de réception 114. Les signaux de réception de toutes les pastilles de réception du premier sous-ensemble de pastilles 80 sont donc tous routés vers un port du ASIC d'interconnexion, correspondant au connecteur 4 QSFP auquel est branché un module émetteur-récepteur QSFP 1 transmettant les signaux à recevoir au niveau du port du ASIC d'interconnexion.

Un connecteur QSFP-DD comprend 16 broches de réception, le second sous-ensemble de pastilles 90 comprend donc 16 pastilles de réception Rx pour la connexion avec ces 16 broches de réception. Les 16 vias dédiés à la réception connectés à ces 16 pastilles de réception Rx permettent donc de récupérer le signal de réception dans les couches 101 et 102. Chaque couche de réception 101 et 102 comprend donc chacune un second sous-ensemble de pistes de réception dédiée à récupérer le signal de réception provenant d'un connecteur QSFP-DD 44 respectivement 113 et 115.

Le second sous-ensemble 113 comprend donc par exemple quatre couples de pistes de réception. Un premier couple de pistes de réception comprend deux pistes de réception, chacune reliée à un via traversant dédié à la réception de la rangée 91. Un second couple de pistes de réception comprend deux pistes de réception, chacune reliée à un via traversant dédié à la réception de la rangée 92. Un troisième couple de pistes de réception comprend deux pistes de réception, chacune reliée à un via traversant dédié à la réception de la rangée 93. Un quatrième couple de pistes de réception comprend deux pistes de réception, chacune reliée à un via traversant dédié à la réception de la rangée 94. Les signaux de réception de huit pastilles de réception sont ainsi récupérés par le second sous-ensemble de pistes de réception 113.

Le second sous-ensemble 115 comprend par exemple quatre autres couples de pistes de réception. Un premier couple de pistes de réception comprend deux pistes de réception, chacune reliée à un via traversant dédié à la réception de la rangée 91, différents des deux vias dédiés à la réception déjà reliés au premier couple de pistes de réception du second sous-ensemble 113. Un second couple de pistes de réception comprend deux pistes de réception, chacune reliée à un via traversant dédié à la réception de la rangée 92, différents des deux vias dédiés à la réception déjà reliés au premier couple de pistes de réception du second sous-ensemble 113. Un troisième couple de pistes de réception comprend deux pistes de réception, chacune reliée à un via traversant dédié à la réception de la rangée 93, différents des deux vias dédiés à la réception déjà reliés au premier couple de pistes de réception du second sous-ensemble 113. Un quatrième couple de pistes de réception comprend deux pistes de réception, chacune reliée à un via traversant dédié à la réception de la rangée 94, différents des deux vias dédiés à la réception déjà reliés au premier couple de pistes de réception du second sous-ensemble 113. Les signaux de réception de huit autres pastilles de réception sont ainsi récupérés par le second sous-ensemble de pistes de réception 115. Les signaux de réception de toutes les pastilles de réception du second sous-ensemble de pastilles 90 sont donc tous routés vers deux ports du ASIC d'interconnexion, correspondant au connecteur 44 QSFP-DD auquel est branché un module émetteur-récepteur QSFP-DD 41 transmettant les signaux à recevoir au niveau des deux ports du ASIC d'interconnexion.

[Fig. 12] représente schématiquement les couches 103 et 104 d'émission du circuit imprimé 3. Ces couches 103 et 104 comprennent une pluralité de pistes d'émission 121. Chaque piste d'émission de la pluralité de pistes d'émission 121 permet de récupérer un signal d'émission et est reliée à un via dédié à l'émission auquel aucune autre piste d'émission de la pluralité de pistes d'émission 121 n'est connectée.

Un signal d'émission provenant du ASIC d'interconnexion est transmis par une piste d'émission de la pluralité de pistes d'émission 121 à un via traversant dédié à l'émission, connecté à une pastille d'émission. La pastille d'émission d'un sous-ensemble de pastilles 80 ou 90 est connectée à une broche d'émission d'un connecteur QSFP 4 ou QSFP-DD 44. Un module émetteur-récepteur QSFP 1 ou QSFP-DD 41 est connecté au connecteur QSFP 4 ou QSFP-DD 44 et récupère le signal d'émission pour l'émettre.

On entend par « piste d'émission » une zone métallisée permettant d'établir un contact entre un via traversant dédié à l'émission de la pluralité de vias traversants 70 et un port du ASIC d'interconnexion.

Un couple de pistes d'émission comprend deux pistes d'émission : une première piste d'émission reliée à un premier via dédié à l'émission et une seconde piste l'émission reliée à un second via traversant dédié à l'émission, voisin du premier via traversant dédié à l'émission.

De la même manière qu'expliqué précédemment pour les pistes d'émission, Chaque couche d'émission 103 et 104 comprend chacune un premier sous-ensemble de pistes d'émission respectivement 122 et 124 dédiée à récupérer le signal d'émission provenant d'un port du ASIC d'interconnexion pour l'acheminer à un ou plusieurs via dédiés à l'émission. Chaque sous-ensemble de pistes d'émission 122 et 124 comprend deux couples de pistes d'émission. Chaque couche d'émission 103 et 104 comprend aussi chacune un second sous-ensemble de pistes d'émission respectivement 123 et 125 dédiée à récupérer le signal d'émission provenant de deux ports du ASIC d'interconnexion pour l'acheminer à un ou plusieurs vias dédiés à l'émission.

Le premier sous-ensemble 122 comprend donc par exemple deux couples de pistes d'émission. Un premier couple de pistes d'émission comprend deux pistes d'émission, chacune reliée à un via traversant dédié à l'émission de la rangée 81. Un second couple de pistes d'émission comprend deux pistes d'émission, chacune reliée à un via traversant dédié à l'émission de la rangée 82. Les signaux d'émission destinés à quatre pastilles d'émission sont ainsi transmis par le premier sous-ensemble de pistes d'émission 122.

Le premier sous-ensemble 124 comprend par exemple deux autres couples de pistes d'émission. Un premier couple de pistes d'émission comprend deux pistes d'émission, chacune reliée à un via traversant dédié à l'émission de la rangée 81, différents des deux vias dédiés à l'émission déjà reliés au premier couple de pistes d'émission du premier sous-ensemble 122. Un second couple de pistes d'émission comprend deux pistes d'émission, chacune reliée à un via traversant dédié à l'émission de la rangée 82, différents des deux vias dédiés à l'émission déjà reliés au premier couple de pistes d'émission du premier sous-ensemble 122. Les signaux d'émission destinés à quatre autres pastilles d'émission sont ainsi transmis par le premier sous-ensemble de pistes d'émission 124. Les signaux d'émission du port du ASIC d'interconnexion sont donc routés vers toutes les pastilles du premier sous-ensemble de pastilles 80, correspondant au connecteur 4 QSFP auquel est branché un module émetteur-récepteur QSFP 1 transmettant les signaux à émettre.

Un connecteur QSFP-DD comprend 16 broches d'émission, le second sous-ensemble de pastilles 90 comprend donc 16 pastilles d'émission Tx pour la connexion avec ces 16 broches d'émission. Les 16 vias dédiés à l'émission connectés à ces 16 pastilles d'émission Tx permettent donc de transmettre le signal d'émission au niveau des couches 103 et 104. Chaque couche d'émission 103 et 104 comprend donc chacune un second sous-ensemble de pistes d'émission respectivement 123 et 125 dédié à transmettre les signaux d'émission provenant de deux ports du ASIC d'interconnexion.

Le second sous-ensemble 123 comprend donc par exemple quatre couples de pistes d'émission. Un premier couple de pistes d'émission comprend deux pistes d'émission, chacune reliée à un via traversant dédié à l'émission de la rangée 91. Un second couple de pistes d'émission comprend deux pistes d'émission, chacune reliée à un via traversant dédié à l'émission de la rangée 92. Un troisième couple de pistes d'émission comprend deux pistes d'émission, chacune reliée à un via traversant dédié à l'émission de la rangée 93. Un quatrième couple de pistes d'émission comprend deux pistes d'émission, chacune reliée à un via traversant dédié à l'émission de la rangée 94. Les signaux d'émission destinés à huit pastilles d'émission sont ainsi transmis par le second sous-ensemble de pistes d'émission 123.

Le second sous-ensemble 125 comprend par exemple quatre autres couples de pistes d'émission. Un premier couple de pistes d'émission comprend deux pistes d'émission, chacune reliée à un via traversant dédié à l'émission de la rangée 91, différents des deux vias dédiés à l'émission déjà reliés au premier couple de pistes d'émission du second sous-ensemble 123. Un second couple de pistes d'émission comprend deux pistes d'émission, chacune reliée à un via traversant dédié à l'émission de la rangée 92, différents des deux vias dédiés à l'émission déjà reliés au premier couple de pistes d'émission du second sous-ensemble 123. Un troisième couple de pistes d'émission comprend deux pistes d'émission, chacune reliée à un via traversant dédié à l'émission de la rangée 93, différents des deux vias dédiés à l'émission déjà reliés au premier couple de pistes d'émission du second sous-ensemble 123. Un quatrième couple de pistes d'émission comprend deux pistes d'émission, chacune reliée à un via traversant dédié à l'émission de la rangée 94, différents des deux vias dédiés à l'émission déjà reliés au premier couple de pistes d'émission du second sous-ensemble 123. Les signaux d'émission destinés à huit autres pastilles d'émission sont ainsi transmis par le second sous-ensemble de pistes d'émission 125. Les signaux d'émission destinés à toutes les pastilles d'émission du second sous-ensemble de pastilles 90 sont donc tous routés depuis les deux ports du ASIC d'interconnexion, correspondant au connecteur 44 QSFP-DD auquel est branché un module émetteur-récepteur QSFP-DD 41 transmettant les signaux à émettre.

L'invention permet donc de router les liens rapides de trois ports d'un ASIC d'interconnexion vers un connecteur QSFP 4 et un connecteur QSFP-DD 44 sur uniquement quatre couches de circuit imprimé 3.

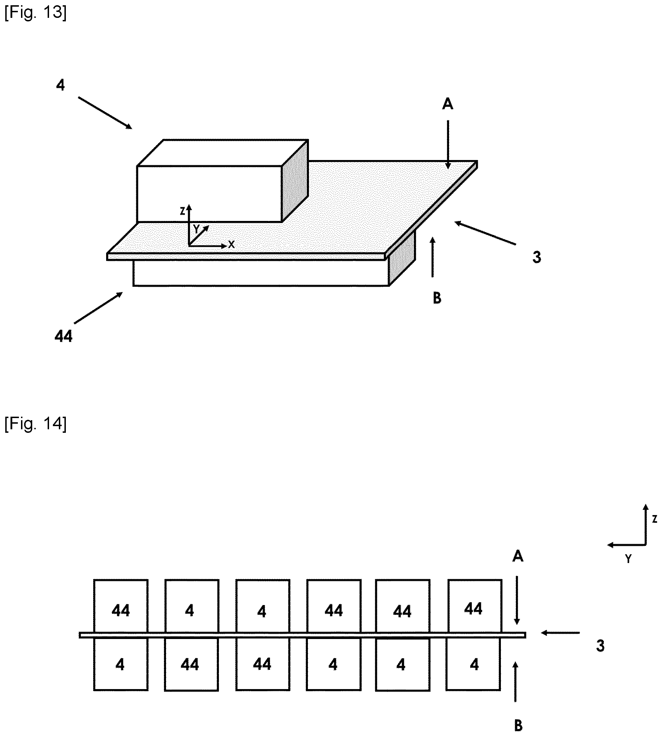

[Fig. 13] représente schématiquement une variante du premier mode de réalisation de l'invention. Dans une variante au premier mode de réalisation représentée Figure 13, il est possible d'avoir le premier sous-ensemble de pastilles 80 pour la connexion avec un connecteur 4 QSFP sur la partie supérieure A du circuit imprimé 3 et le second sous-ensemble de pastilles 90 pour la connexion avec un connecteur QSFP-DD 44 sur la partie inférieure B du circuit imprimé 3.

Dans un second mode de réalisation, le circuit imprimé 3 peut comprendre une pluralité de premiers sous-ensembles de pastilles 80 pour la connexion avec un connecteur 4 QSFP et une pluralité de second sous-ensembles de pastilles 90, chaque premier sous-ensemble permettant la connexion avec un connecteur QSFP 4 et chaque second sous-ensemble de pastilles 90 permettant la connexion avec un connecteur QSFP-DD 44. Tous les premiers sous-ensembles de pastilles 80 peuvent se situer sur une même première face du circuit imprimé 3. Dans ce cas, tous les seconds sous-ensembles de pastilles 90 se situent sur une même seconde face, opposée à la première face.

[Fig. 14] représente schématiquement un troisième mode de réalisation dans lequel un connecteur QSFP 4 est toujours situé sur une face opposée à un connecteur QSFP-DD 44, et où tous les connecteurs QSFP 4 ne sont pas situés sur la même face du circuit imprimé 3. Dans ce troisième mode de réalisation, certains premiers sous-ensembles de pastilles 80 de la pluralité de premiers sous-ensembles de pastilles 80 se situent sur une première face du circuit imprimé 3 et d'autres premiers sous-ensembles de pastilles 80 de la pluralité de premiers sous-ensembles de pastilles 80 se situent sur la seconde face du circuit imprimé 3, opposée à la première face. Lorsque c'est le cas, pour chaque premier sous-ensemble de pastilles 80 de la pluralité de premiers sous-ensembles de pastilles 80 situé sur la première face, se situera alors sur seconde face, opposée à la première face, aligné selon l'axe transversal Z, un second sous-ensemble de pastilles 90. De la même manière, pour chaque premier sous-ensemble de pastilles 80 de la pluralité de premiers sous-ensembles de pastilles 80 situé sur la seconde face, se situera alors sur la première face, opposée à la seconde face, aligné selon l'axe transversal Z, un second sous-ensemble de pastilles 90. Ainsi, il est possible d'avoir un circuit imprimé 3 auquel il est possible de connecter des connecteurs QSFP 4 en Belly-To-Belly avec des connecteurs QSFP-DD 44 sans utiliser de technologies PCB complexes et coûteuses telles que des microvias ou des PCB multipressés.

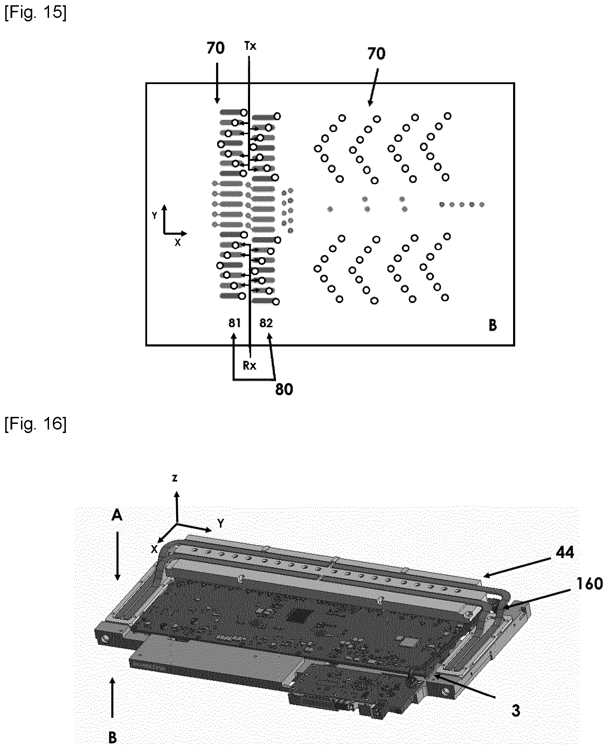

[Fig. 15] représente une variante au premier mode de réalisation de l'invention dans lequel au moins les vias dédiés à l'émission et les vias dédiés à la réception chevauchent les pastilles d'émission et de réception auquel ils sont connectés, c'est-à-dire qu'ils les trouent, permettant de réaliser la connexion entre la pastille d'émission ou de réception et les différentes couches.

Dans ce mode de réalisation, au moins les vias dédiés à la réception et au moins les vias dédiés à l'émission de la pluralité de vias traversants 70 sont réalisés directement dans les pastilles de réception et/ou d'émission. On les appelle les « vias in pad » selon la dénomination anglaise « via dans la pastille ». Ces vias in pad sont aussi décalés selon l'axe longitudinal X par rapport au via voisin afin de créer une diagonale comme représenté à la Figure 15. Cela permet d'avoir un espacement de 1 millimètre entre les vias in pad et ainsi d'avoir un diamètre plus important de vias traversants 70 possibles pour respecter l'impédance de 100 ohms. L'ensemble des vias traversants dédiés à la réception d'une rangée, par exemple de la rangée 81 forme alors un chevron. L'ensemble des vias traversants dédiés à l'émission d'une rangée, par exemple la rangée 81, forme aussi un chevron. Pour chaque rangée, l'ensemble des vias traversants comprenant les vias traversants dédiés à l'émission et les vias traversants dédiés à l'émission forme deux chevrons. La Figure 15 représente ces deux chevrons formés par les vias traversants 70 sur chaque rangée.

L'invention concerne aussi un système d'interconnexion comprenant au moins le circuit imprimé 3 selon l'un quelconque des modes de réalisation précédents et comprenant au moins un connecteur QSFP disposé en Belly-To-Belly avec un connecteur QSFP-DD. On ne sort pas du cadre de l'invention lorsque l'on a un commutateur d'interconnexion comprenant un circuit imprimé et des connecteurs QSFP en Belly-To-Belly connus de l'état de la technique et au moins un couple de connecteurs QSFP 4 et QSFP-DD 44 en Belly-To-Belly. Pour avoir plusieurs connecteurs QSFP 4 en Belly-To-Belly, le circuit imprimé 3 peut par exemple comprendre des troisièmes sous-ensembles de pastilles et des quatrièmes sous-ensembles de pastilles, les troisièmes sous-ensembles de pastilles permettant la connexion avec un connecteur QSFP 4 sur une première face du circuit imprimé 3 et les quatrièmes sous-ensembles de pastilles permettant la connexion avec un connecteur QSFP 4 sur une deuxième face du circuit imprimé 3, de façon à avoir à chaque fois deux connecteurs QSFP 4 en Belly-To-Belly.

Ainsi, il est possible d'avoir un commutateur d'interconnexion 19 pouces 1U comprenant plus de 40 ports d'un ASIC d'interconnexion avec seulement 40 connecteurs en façade. Dans le cas où un seul couple de connecteurs QSFP 4 et QSFP-DD 44 en Belly-To-Belly est compris par le commutateur d'interconnexion et où les autres connecteurs du commutateur d'interconnexion 19 pouces 1U sont des connecteurs QSFP 4 en Belly-To-Belly, le commutateur d'interconnexion comprend alors 41 ports d'ASIC d'interconnexion disponibles pour un encombrement en façade de 40 connecteurs. Le commutateur d'interconnexion comprend alors 2 ports répartis sur les connecteurs QSFP-DD 44 et 19 ports répartis sur les connecteurs QSFP 4.

Dans le cas où le nombre maximal de couples de connecteurs QSFP 4 et QSFP-DD 44 en Belly-To-Belly est compris par le commutateur d'interconnexion, le commutateur d'interconnexion comprend alors 20 couples de connecteurs QSFP 4 et QSFP-DD 44 en Belly-To-Belly et donc 60 ports d'ASIC d'interconnexion accessibles pour un encombrement en façade de 40 connecteurs. Le commutateur d'interconnexion comprend alors 40 ports répartis sur les connecteurs QSFP-DD 44 et 20 ports répartis sur les connecteurs QSFP 4.

Un avantage supplémentaire de l'invention est de pouvoir avoir jusqu'à 60 ports sur un commutateur d'interconnexion tout en ayant un système de refroidissement efficace, par exemple un système de refroidissement liquide, permettant de refroidir des connecteurs QSFP-DD 44. En effet, lorsque les cages QSFP-DD et QSFP 2 ont une surface supérieure plane dans la disposition en Belly-To-Belly, il est alors possible d'utiliser un système de refroidissement liquide tel que représenté à la Figure 16.

[Fig. 16] représente schématiquement un commutateur d'interconnexion selon l'invention comprenant au moins un couple de connecteurs QSFP 4 et QSFP-DD 44 disposés en Belly-To-Belly. Le commutateur d'interconnexion comprend par exemple un système de refroidissement 160, par exemple un système de refroidissement liquide, permettant de refroidir efficacement les connecteurs QSFP 4 et QSFP-DD 44 et les modules émetteur-récepteur QSFP 1 et QSFP-DD 41 connectés aux connecteurs QSFP 4 et QSFP-DD 44 grâce à la disposition en Belly-To-Belly. Ce système de refroidissement efficace peut être par exemple un système de refroidissement fluidique1. L'utilisation de cages ayant une surface plane comme représenté sur la Figure 16 permet une efficacité accrue de ce système de refroidissement 160.

## Revendications

1. Circuit imprimé comprenant :
- une première face ;
- une deuxième face opposée à la première face ;
- une pluralité de vias traversants ;
- un ensemble de pastilles comprenant une pluralité de pastilles de réception, et une pluralité de pastilles d'émission ; chaque pastille de réception de la pluralité de pastilles de réception étant dédiée à la connexion à une broche de réception d'un connecteur QSFP ou d'un connecteur QSFP-DD ; chaque pastille d'émission de la pluralité de pastilles d'émission étant dédiée à la connexion à une broche d'émission d'un connecteur QSFP ou d'un connecteur QSFP-DD ;
ledit circuit imprimé comprenant :
- un premier sous-ensemble de pastilles, compris dans l'ensemble de pastilles, pour assurer la connexion avec un premier connecteur choisi parmi un ensemble de connecteurs comprenant un connecteur QSFP et un connecteur QSFP-DD, sur la première face,
- un second sous-ensemble de pastilles compris dans l'ensemble de pastilles, pour assurer la connexion avec un second connecteur, choisi différent du premier connecteur parmi ledit ensemble de connecteurs, sur la deuxième face, ledit second sous-ensemble étant décalé par rapport au premier sous-ensemble de pastilles selon un axe longitudinal du circuit imprimé, de façon qu'aucune pastille du second sous-ensemble de pastilles ne soit en regard d'une pastille du premier sous-ensemble de pastilles,
- une pluralité de vias traversants dédiés à la réception, chaque via traversant dédié à la réception de la pluralité de vias traversants dédiés à la réception étant connecté à une pastille de réception de la pluralité de pastilles, chaque pastille de réception étant connectée à un via traversant dédié à la réception,
- une pluralité de vias traversants dédiés à l'émission, chaque via traversant dédié à l'émission de la pluralité de vias traversants dédiés à l'émission étant connecté à une pastille d'émission de la pluralité de pastilles, chaque pastille d'émission étant connectée à un via traversant dédié à l'émission,
- un ensemble de quatre couches comprenant :
∘ deux couches de réception comprenant une pluralité de pistes de réception, chacune des pistes de réception de la pluralité de pistes de réception étant reliée à un via de réception de la pluralité de vias de réception auquel aucune autre piste de réception n'est reliée,
∘ deux couches d'émission comprenant une pluralité de pistes d'émission, chaque piste d'émission de la pluralité de pistes d'émission étant reliée à un via d'émission auquel aucune autre piste d'émission n'est reliée,
- la pluralité de pistes de réception comprenant une pluralité de couples de pistes de réception, chaque couple de pistes de réception comprenant :
∘ une première piste de réception reliée à un premier via traversant dédié à la réception et une seconde piste de réception reliée à un second via traversant dédié à la réception, voisin du premier via traversant dédié à la réception,
- la pluralité de pistes d'émission comprenant une pluralité de couples de pistes d'émission, chaque couple de pistes d'émission comprenant :
∘ une première piste d'émission reliée à un premier via traversant dédié à l'émission et une seconde piste d'émission reliée à un second via traversant dédié à l'émission, voisin du premier via traversant dédié à l'émission,
- chaque via traversant dédié à la réception étant relié à une piste de réception et chaque via traversant dédié à l'émission étant relié à une piste d'émission.

2. Circuit imprimé selon la revendication précédente **caractérisé en ce que** chaque via traversant de la pluralité de vias traversants ne chevauche aucune pastille de la pluralité de pastille.

3. Circuit imprimé selon la revendication précédente **caractérisé en ce que** la distance entre chaque via de la pluralité de via est d'au moins 0.8 millimètres.

4. Circuit imprimé selon la revendication 1 **caractérisé en ce qu'**au moins un via traversant dédié à la réception de la pluralité de vias traversants dédiés à la réception chevauche une pastille de réception de la pluralité de pastilles et **en ce qu'**au moins un via traversant dédié à l'émission de la pluralité de vias traversants dédiés à l'émission chevauche une pastille d'émission de la pluralité de pastilles.

5. Circuit imprimé selon l'une quelconque des revendications précédentes **caractérisé en ce qu'**il comprend en outre un troisième sous-ensemble de pastilles compris dans la pluralité de pastilles et un quatrième sous-ensemble de pastilles compris dans la pluralité de pastilles, chaque troisième sous-ensemble de pastilles permettant la connexion avec un connecteur QSFP sur la première face et chaque quatrième sous ensemble de pastilles permettant la connexion avec un connecteur QSFP sur la deuxième face.

6. Circuit imprimé selon la revendication précédente **caractérisé en ce qu'**il comprend une pluralité de troisièmes sous-ensembles de pastilles et une pluralité de quatrièmes sous-ensembles de pastilles, de manière à ce qu'il y ait autant de troisièmes sous-ensembles de pastilles que de quatrièmes sous-ensembles de pastilles.

7. Circuit imprimé selon l'une quelconque des revendications précédentes **caractérisé en ce qu'**il comprend une pluralité de premiers sous-ensembles de pastilles et une pluralité de seconds sous-ensembles de pastilles, de manière à ce qu'il y ait autant de premiers sous-ensembles de pastilles que de seconds sous-ensembles de pastilles.

8. Système d'interconnexion **caractérisé en ce qu'**il comprend le circuit imprimé selon l'une quelconque des revendications précédentes, un ensemble de connecteurs comprenant au moins un connecteur QSFP et au moins un connecteur QSFP-DD, **en ce que** chaque connecteur QSFP de l'ensemble de connecteurs est connecté à un sous-ensemble de pastilles permettant la connexion à connecteur QSFP, **en ce que** chaque connecteur QSFP-DD de l'ensemble de connecteurs est connecté à un sous-ensemble de pastilles permettant la connexion à un connecteur QSFP-DD, chaque sous-ensemble étant connecté à un seul connecteur de l'ensemble de connecteurs, chaque connecteur de l'ensemble de connecteurs étant connecté à un seul sous-ensemble de pastilles et au moins un couple de connecteurs comprenant un connecteur QSFP et un connecteur QSFP-DD disposés en Belly-To-Belly.

9. Système d'interconnexion selon la revendication précédente **caractérisé en ce qu'**il est un commutateur d'interconnexion ayant une largeur permettant de respecter le standard 19 pouces et ayant une hauteur d'une unité de rack.

10. Système d'interconnexion selon l'une quelconque des revendications 8 ou 9 **caractérisé en ce qu'**il comprend en outre un ASIC d'interconnexion comprenant au moins 41 ports.

11. Système d'interconnexion selon l'une quelconque des revendications 8 à 10 **caractérisé en ce qu'**il comprend un système de refroidissement liquide connecté à au moins une cage QSFP et à au moins une cage QSFP-DD, la au moins une cage QSFP se situant sur la première face du circuit imprimé et la au moins une cage QSFP-DD se situant sur la deuxième face du circuit imprimé.

## Patentansprüche

1. Gedruckte Schaltung, umfassend:
- eine erste Fläche;
- eine zweite Fläche gegenüber der ersten Fläche;
- eine Vielzahl von Durchgangskontaktierungen;
- eine Anordnung von Chips, umfassend eine Vielzahl von Empfangschips und eine Vielzahl von Sendechips; wobei jeder Empfangschip der Vielzahl von Empfangschips für die Verbindung mit einem Empfangsstift eines QSFP-Steckers oder eines QSFP-DD-Steckers vorgesehen ist; wobei jeder Sendechip der Vielzahl von Sendechips für die Verbindung mit einem Sendestift eines QSFP-Steckers oder eines QSFP-DD-Steckers vorgesehen ist;
wobei die gedruckte Schaltung umfasst:
- eine erste Teilgruppe von Chips, die in der Anordnung von Chips enthalten sind, um die Verbindung mit einem ersten Stecker sicherzustellen, der aus einer Anordnung von Steckern ausgewählt ist, umfassend einen QSFP-Stecker und einen QSFP-DD-Stecker auf der ersten Fläche,
- eine zweite Teilgruppe von Chips, die in der Anordnung von Chips enthalten ist, um die Verbindung mit einem zweiten Stecker sicherzustellen, der anders als der erste Stecker aus der Anordnung von Steckern ausgewählt ist, auf der zweiten Fläche, wobei die zweite Teilgruppe relativ zu der ersten Teilgruppe von Chips entlang einer Längsachse der gedruckten Schaltung versetzt ist, so dass kein Chip der zweiten Teilgruppe von Chips einem Chip der ersten Teilgruppe von Chips gegenüberliegt,
- eine Vielzahl von Durchkontaktierungen, die für den Empfang vorgesehen ist, wobei jede Durchkontaktierung, die für den Empfang vorgesehen ist, der Vielzahl von Durchkontaktierungen, die für den Empfang vorgesehen ist, mit einem Empfangschip der Vielzahl von Chips verbunden ist, wobei jeder Empfangschip mit einer Durchkontaktierung verbunden ist, die für den Empfang vorgesehen ist,
- eine Vielzahl von Durchkontaktierungen, die für die Sendung vorgesehen ist, wobei jede Durchkontaktierung, die für die Sendung vorgesehen ist, der Vielzahl von Durchkontaktierungen, die für die Sendung vorgesehen ist, mit einem Sendechip der Vielzahl von Chips verbunden ist, wobei jeder Sendechip mit einer Durchkontaktierung verbunden ist, die für die Sendung vorgesehen ist,
- eine Anordnung aus vier Schichten, umfassend:
∘ zwei Empfangsschichten, umfassend eine Vielzahl von Empfangsspuren, wobei jede der Empfangsspuren der Vielzahl von Empfangsspuren mit einer Empfangskontaktierung der Vielzahl von Empfangskontaktierungen verbunden ist, mit der keine andere Empfangsspur verbunden ist,
o zwei Sendeschichten, umfassend eine Vielzahl von Sendespuren, wobei jede Sendespur der Vielzahl von Sendespuren mit einer Sendekontaktierung verbunden ist, mit der keine andere Sendespur verbunden ist,
- die Vielzahl von Empfangsspuren, umfassend eine Vielzahl von Paaren von Empfangsspuren, wobei jedes Paar von Empfangsspuren umfasst:
o eine erste Empfangsspur, die mit einer ersten Durchkontaktierung, die für den Empfang vorgesehen ist, verbunden ist, und eine zweite Empfangsspur, die mit einer zweiten Durchkontaktierung, die für den Empfang vorgesehen ist, verbunden ist, die der ersten Durchkontaktierung, die für den Empfang vorgesehen ist, ähnlich ist,
- die Vielzahl von Sendespuren, umfassend eine Vielzahl von Paaren von Sendespuren, wobei jedes Paar von Sendespuren umfasst:
o eine erste Sendespur, die mit einer ersten Durchkontaktierung, die für die Sendung vorgesehen ist, verbunden ist, und eine zweite Sendespur, die mit einer zweiten Durchkontaktierung, die für die Sendung vorgesehen ist, verbunden ist, die der ersten Durchkontaktierung, die für die Sendung vorgesehen ist, ähnlich ist,
- wobei jede für den Empfang vorgesehene Durchkontaktierung mit einer Empfangsspur verbunden ist und jede für die Sendung vorgesehene Durchkontaktierung mit einer Sendespur verbunden ist.

2. Gedruckte Schaltung nach dem vorstehenden Anspruch,
**dadurch gekennzeichnet, dass** jede Durchkontaktierung der Vielzahl von Durchkontaktierungen keinen Chip der Vielzahl von Chips überlappt.

3. Gedruckte Schaltung nach dem vorstehenden Anspruch,
**dadurch gekennzeichnet, dass** der Abstand zwischen jeder Durchkontaktierung der Vielzahl von Durchkontaktierungen mindestens 0,8 Millimeter beträgt.

4. Gedruckte Schaltung nach Anspruch 1, **dadurch gekennzeichnet, dass** mindestens eine Durchkontaktierung, die für den Empfang vorgesehen ist, der Vielzahl von Durchkontaktierungen, die für den Empfang vorgesehen ist, einen Empfangschip der Vielzahl von Chips überlappt und **dass** mindestens eine Durchkontaktierung, die für die Sendung vorgesehen ist, der Vielzahl von Durchkontaktierungen, die für die Sendung vorgesehen ist, einen Sendechip der Vielzahl von Chips überlappt.

5. Gedruckte Schaltung nach einem der vorstehenden Ansprüche,
**dadurch gekennzeichnet, dass** sie ferner eine dritte Teilgruppe von Chips, die in der Vielzahl von Chips enthalten sind, und eine vierte Teilgruppe von Chips, die in der Vielzahl von Chips enthalten ist, wobei jede dritte Teilgruppe von Chips die Verbindung mit einem QSFP-Stecker auf der ersten Fläche ermöglicht und jede vierte Teilgruppe von Chips die Verbindung mit einem QSFP-Stecker auf der zweiten Fläche ermöglicht.

6. Gedruckte Schaltung nach dem vorstehenden Anspruch,
**dadurch gekennzeichnet, dass** sie eine Vielzahl von dritten Teilgruppen von Chips und eine Vielzahl von vierten Teilgruppen von Chips umfasst, so dass es so viele dritte Teilgruppen von Chips wie vierte Teilgruppen von Chips gibt.

7. Gedruckte Schaltung nach einem der vorstehenden Ansprüche, **dadurch gekennzeichnet, dass** sie eine Vielzahl von ersten Teilgruppen von Chips und eine Vielzahl von zweiten Teilgruppen von Chips umfasst, so dass es so viele erste Teilgruppen von Chips wie zweite Teilgruppen von Chips gibt.

8. Zusammenschaltungssystem, **dadurch gekennzeichnet, dass** es die gedruckte Schaltung nach einem der vorstehenden Ansprüche, eine Steckeranordnung, umfassend mindestens einen QSFP-Stecker und mindestens einen QSFP-DD-Stecker, **dass** jeder QSFP-Stecker der Steckeranordnung mit einer Teilgruppe von Chips verbunden ist, die die Verbindung mit dem QSFP-Stecker ermöglicht, **dass** jeder QSFP-DD-Stecker der Steckeranordnung mit einer Teilgruppe von Chips verbunden ist, die die Verbindung mit einem QSFP-DD-Stecker ermöglicht, wobei jede Teilgruppe mit einem einzelnen Stecker der Steckeranordnung verbunden ist, wobei jeder Stecker der Steckeranordnung mit einer einzelnen Teilgruppe von Chips und mindestens einem Paar von Steckern verbunden ist, umfassend einen QSFP-Stecker und einen QSFP-DD-Stecker, angeordnet in einer Belly-to-Belly-Anordnung.

9. Zusammenschaltungssystem nach dem vorstehenden Anspruch, **dadurch gekennzeichnet, dass** es sich um einen Zusammenschaltungsschalter, der eine Breite vorweist, die es ermöglicht, den 19-Zoll-Standard einzuhalten, und eine Höhe einer Höheneinheit vorweist.

10. Zusammenschaltungssystem nach einem der Ansprüche 8 oder 9, **dadurch gekennzeichnet, dass** sie ferner einen Verbindungs-ASIC umfasst, umfassend mindestens 41 Ports.

11. Zusammenschaltungssystem nach einem der Ansprüche 8 bis 10, **dadurch gekennzeichnet, dass** sie ein Flüssigkeitskühlsystem, das mit mindestens einem QSFP-Käfig und mit mindestens einem QSFP-DD-Käfig verbunden ist, wobei der mindestens eine QSFP-Käfig sich auf der ersten Fläche der gedruckten Schaltung und der mindestens eine QSFP-DD-Käfig sich auf der zweiten Fläche der gedruckten Schaltung befindet.

## Claims

1. Printed circuit board comprising:
- a first face;
- a second face opposite the first face;
- a plurality of through-vias;
- a set of pads comprising a plurality of receiving pads and a plurality of transmission pads; each receiving pad of the plurality of receiving pads being intended for connecting to a receiving pin of a QSFP connector or a QSFP-DD connector; each transmission pad of the plurality of transmission pads being intended for connecting to a transmission pin of a QSFP connector or a QSFP-DD connector;
said printed circuit board comprising:
- a first sub-set of pads, included in the set of pads, for connecting to a first connector selected from a set of connectors comprising a QSFP connector and a QSFP-DD connector, on the first face,
- a second sub-set of pads included in the set of pads, for connecting to a second connector, selected to be different from the first connector from said set of connectors, on the second face, said second sub-set being offset with respect to the first sub-set of pads along a longitudinal axis of the printed circuit board, such that no pad of the second sub-set of pads faces a pad of the first sub-set of pads,
- a plurality of through-vias intended for reception, each through-via intended for reception of the plurality of through-vias intended for reception being connected to a receiving pad of the plurality of pads, each receiving pad being connected to a through-via intended for reception,
- a plurality of through-vias intended for transmission, each through-via intended for transmission of the plurality of through-vias intended for transmission being connected to a transmission pad of the plurality of pads, each transmission pad being connected to a through-via intended for transmission,
- a set of four layers comprising:
∘ two receiving layers comprising a plurality of receiving tracks, each receiving track of the plurality of receiving tracks being linked to a receiving via of the plurality of receiving vias to which no other receiving track is linked,
∘ two transmission layers comprising a plurality of transmission tracks, each transmission track of the plurality of transmission tracks being linked to a transmission via to which no other transmission track is linked,
- the plurality of receiving tracks comprising a plurality of receiving track pairs, each receiving track pair comprising:
∘ a first receiving track which is linked to a first through-via intended for reception and a second receiving track which is linked to a second through-via intended for reception, which is adjacent to the first through-via intended for reception,
- the plurality of transmission tracks comprising a plurality of transmission track pairs, each transmission track pair comprising:
∘ a first transmission track which is linked to a first through-via intended for transmission and a second transmission track which is linked to a second through-via intended for transmission, which is adjacent to the first through-via intended for transmission,
- each through-via intended for reception being linked to a receiving track and each through-via intended for transmission being linked to a transmission track.

2. Printed circuit board according to the preceding claim, **characterized in that** each through-via of the plurality of through-vias does not overlap any pad of the plurality of pad.

3. Printed circuit board according to the preceding claim, **characterized in that** the distance between each via of the plurality of via is at least 0.8 millimeters.

4. Printed circuit board according to claim 1, **characterized in that** at least one through-via intended for reception of the plurality of through-vias intended for reception overlaps a receiving pad of the plurality of pads and **in that** at least one through-via intended for transmission of the plurality of through-vias intended for transmission overlaps a transmission pad of the plurality of pads.

5. Printed circuit board according to any one of the preceding claims, **characterized in that** it further comprises a third sub-set of pads included in the plurality of pads and a fourth sub-set of pads included in the plurality of pads, each third sub-set of pads enabling the connection with a QSFP connector on the first face and each fourth sub-set of pads enabling the connection with a QSFP connector on the second face.

6. Printed circuit board according to the preceding claim,
**characterized in that** it comprises a plurality of third sub-sets of pads and a plurality of fourth sub-sets of pads, in such a way that there are as many third sub-sets of pads as there are fourth sub-sets of pads.

7. Printed circuit board according to any one of the preceding claims, **characterized in that** it comprises a plurality of first sub-sets of pads and a plurality of second sub-sets of pads, in such a way that there are as many first sub-sets of pads as there are second sub-sets of pads.

8. Interconnection system, **characterized in that** it comprises the printed circuit board according to any one of the preceding claims, a set of connectors comprising at least one QSFP connector and at least one QSFP-DD connector, **in that** each QSFP connector of the set of connectors is connected to a sub-set of pads enabling the connection to a QSFP connector, **in that** each QSFP-DD connector of the set of connectors is connected to a sub-set of pads enabling the connection to a QSFP-DD connector, each sub-set being connected to a single connector of the set of connectors, each connector of the set of connectors being connected to a single sub-set of pads and at least one pair of connectors comprising a QSFP connector and a QSFP-DD connector arranged in Belly-To-Belly configuration.

9. Interconnection system according to the preceding claim,
**characterized in that** it is an interconnection switch having a width compliant with the 19-inch standard and having a height of one rack unit.

10. Interconnection system according to any one of claims 8 or 9, **characterized in that** it further comprises an interconnection ASIC comprising at least 41 ports.

11. Interconnection system according to any one of claims 8 to 10, **characterized in that** it comprises a liquid cooling system connected to at least one QSFP cage and to at least one QSFP-DD cage, the at least one QSFP cage being located on the first face of the printed circuit board and the at least one QSFP-DD cage being located on the second face of the printed circuit board.
